(19) **Europäisches Patentamt**

**European Patent Office**

**Office européen des brevets**

(11) **EP 1 016 882 A2**

(12) **EUROPEAN PATENT APPLICATION**

(43) Date of publication:
05.07.2000 Bulletin 2000/27

(51) Int. Cl.$^7$: **G01T 1/29**

(21) Application number: **00300018.9**

(22) Date of filing: **05.01.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **31.12.1998 IL 12787998**

(71) Applicant:
**Integrated Detector & Electronics AS
1322 Hovik (NO)**

(72) Inventor: **Nygard, Einar
1344 Haslum (NO)**

(74) Representative:
**Tomlinson, Kerry John
Frank B. Dehn & Co.,
European Patent Attorneys,
179 Queen Victoria Street
London EC4V 4EL (GB)**

(54) **Output circuit for a charge detector**

(57) An input circuit (30) for a charge detector having a sensor element (31, 41, 51), the input circuit comprising an amplifier (33, 42, 52) having an input terminal and an output terminal, the sensor element (31, 41, 51) being coupled to the input terminal for feeding a data signal thereto upon detection of a high energy particle and passing a leakage current in an absence of a high energy particle. A controlled current source (32, 40, 50) is coupled to the sensor element for feeding a major component of the leakage current therethrough, and a feedback resistor (34, 43, 53) is coupled across the input terminal and the output terminal of the amplifier for feeding a residual component of the leakage current to the sensor element. The controlled current source typically constituted by a MOSFET is responsive to a change in voltage across the feedback resistor for regulating the major component of the leakage current so as to maintain the residual component thereof substantially constant.

FIG.3

EP 1 016 882 A2

**Description**

**FIELD OF THE INVENTION**

This invention relates to a charge detector for reading charge produced by an active pixel in the detector.

**BACKGROUND OF THE INVENTION**

A known diagnostic technique used in tomography for locating tumors involves injecting into a patient's bloodstream a radioactive isotope which targets the tumor, so that the location of the tumor can be derived by detecting the location of the radioactive isotope. Typically, the radioactive isotope emits high energy γ-rays which are dispersed from the tumor site. In order to achieve the desired detection so as to determine the precise location of the tumor, it is necessary to image the patient's body in such a manner as to detect only those γ-rays which are emitted normally from the body and to ignore those γ-rays which are dispersed in other directions.

For the purpose of the present invention, the Compton camera may be regarded as just another type of 2-dimensional image sensor having a plurality of addressable pixels, one of which emits a signal when stimulated by a γ-ray. Specifically, each pixel is a diode which generates a charge signal when hit by a γ-ray. A γ-ray emitted by the radioisotope will be detected only if it creates a Compton effect by creating a charge signal thereby giving up some of its energy. In practice, it is usual to employ a composite sensor having several spaced-apart sensor layers each containing at least one sensor module so as to increase the probability that an incident γ-ray will produce a Compton effect in at least one of the layers. The multilayer sensor module constitutes a first detector of the Compton camera. Having thus produced a Compton effect, the γ-ray then emerges from the first detector. However, in order to calculate the angle of the incident γ-ray, the emergent γ-ray is directed to a second detector in which it is absorbed completely, thereby giving up all of its residual energy.

The principles of the Compton effect as used in γ-ray cameras are well described in U.S. Patent No. 4,529,882 to Lee which describes a Compton scattering γ-radiation camera and method of creating radiological images. Thus, essentially such a camera comprises a detector formed of a solid-state semiconductor material for generating electron-hole pairs when collided with by photons. The camera further allows identification of an ordered pair of such collisions in which both collisions result from the same photon. Photons can interact with semiconductors in essentially three ways. Thus, in the first case, Compton scattering results from a collision between a first photon and an atom of the semiconductor whereby the first photon is converted into a second photon emitted by the collision at an angle varying between zero and 180° with the original path of the first photon. Compton scattering collision causes the emitted photon it produces to have less energy than the incident photon which causes the collision.

The second type of collision which a photon can have with a semiconductor is photoelectric absorption, whereby the photon is arrested by the collision thus giving up all of its energy to the formation of electron-hole pairs. Thus, when photoelectric absorption occurs, the energy of the photon which has been absorbed can be determined by detecting the number of electron-hole pairs produced.

The third type of collision which a photon can have with a semiconductor is pair production, whereby the photon is absorbed and its energy converted into the production of an electron-positron pair. This, however, can occur only at very high energy levels of incident radiation exceeding that of γ-rays which are most commonly employed.

When used for medical imaging, γ-ray cameras must be able, after suitable processing, to provide an indication of a tumor's position in the body. To this end, the tumor is rendered radioactive using a radioactive tracer and is bombarded with γ-radiation in order to produce Compton scattering. The resulting first and second photons are detected by respective detectors. The energy of the second photon is always less than that of the first incident photon by an amount which is a function of the angle of Compton scattering. For this reason, the peak energies of the first and second photons must be determined accurately since knowing the angle of Compton scattering allows the tumor's location to be inferred according to the equation:

$$\theta = \arccos\left(1 + \frac{511\text{keV}}{E_1 + E_2} - \frac{511\text{keV}}{E_2}\right)$$

where:

$\theta$ is angle of Compton scattering,
$E_1$ is the peak energy of the first photon,
$E_2$ is the peak energy of the second photon, and
511 keV is the energy of the incident γ-radiation.

So far as the present invention is concerned, when a γ-ray strikes a pixel in the charge detector, the resulting electrons which are thereby produced gives rises to a flow of charge which may be measured. As is described in EP 893,705 published on January 27, 1999 in the name of the present applicant, the charge detector essentially comprises two components: a pixel array and a reading circuit built as an ASIC (application-specific integrated circuit). Each pixel in the pixel array is constituted by a reverse biased diode having an associated reverse leakage current of approximate amplitude 1 nA. When a γ-ray strikes the diode, the diode becomes momentarily forward biased, thereby giving rise to charge flow across the diode's depletion layer.

In a silicon diode, the effective width of the depletion layer corresponds to an energy gap of 3.6eV. γ-rays have an energy typically in the order of 140 keV, thus yielding approximately 40,000 free charges per γ-ray. These charges give rise to a current whose value is inversely proportional to the time taken to collect the charges, being typically 20 ns. The resultant current signal appears as a sharp peak typically in the order of 300 nA in amplitude above the baseline of 1 nA produced by the leakage current.

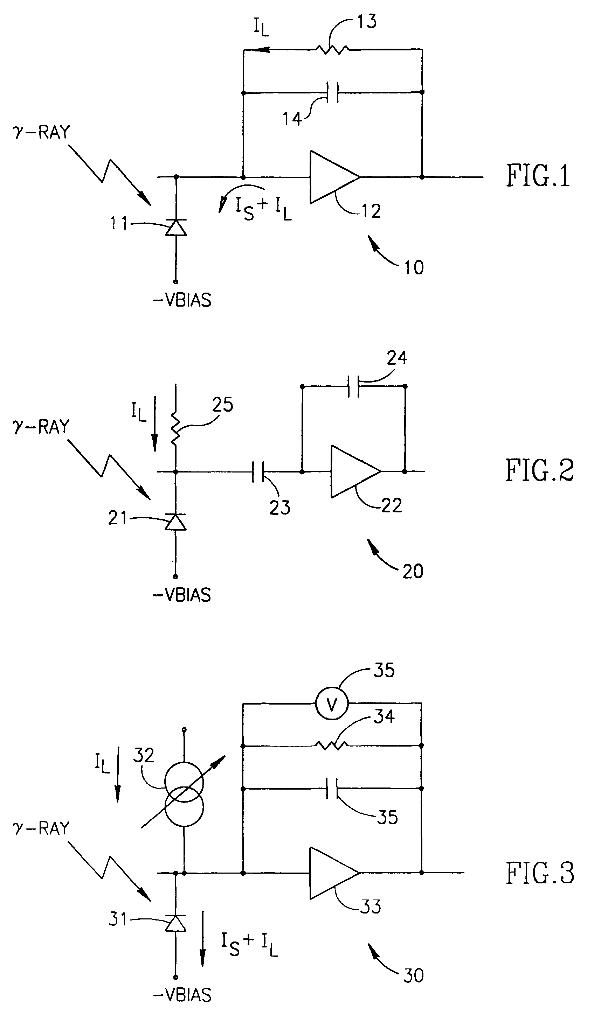

Fig. 1 shows schematically part of a prior art reading circuit depicted generally as 10 for reading a pixel constituted by a reverse biased diode 11. For each diode in the pixel array, the ASIC includes an OP-AMP 12 having a feedback resistor 13 and capacitor 14 operating as a charge integrator that outputs an electric current proportional to the charge produced by the γ-ray striking the diode 11. The reverse leakage current of the diode 11 is shown as $I_L$, whilst the current produced when a γ-ray strikes the diode 11 is shown as $I_S$. Under steady-state conditions, when no γ-ray is absorbed, only the small leakage current $I_L$ flows through the diode 11, this flowing via the feedback resistor 13. Typically, the value of the feedback resistor 13 is in excess of 100 MΩ in order to achieve low noise. Thus, even assuming that the magnitude of the leakage current $I_L$ is as low as 1 nA, the voltage drop across the feedback resistor is a significant 0.1 volt. In fact, the leakage current $I_L$ may well be somewhat higher than the optimum value of 1 nA in which case, of course, the voltage drop across the feedback resistor will be greater than 0.1 volt. This not only increases the power dissipation of the OP-AMP 12 but, much more seriously, wrongly biases the OP-AMP 12 causing saturation and degrading its ability to measure the actual signal $I_S$ when a γ-ray strikes the pixel.

Fig. 2 shows schematically a conventional prior art solution to this problem. Thus, a circuit 20 is depicted operationally equivalent to the circuit 10 shown in Fig. 1 but having a slightly re-arranged topology. In this case, there is shown a pixel constituted by a reverse-biased diode 21 whose cathode is connected to the input of an OP-AMP 22 via a DC blocking capacitor 23. A feedback capacitor 24 is connected across the OP-AMP 22 so as to form a conventional charge integrator, similar to that shown in Fig. 1. However, in the circuit topology shown in Fig. 2, the feedback resistor is constituted by a resistor 25 connected between GND and the cathode of the diode 21 so as to feed the reverse leakage current $I_L$ therethrough. Under steady-state conditions, when no γ-ray is absorbed, only the small leakage current $I_L$ flows through the diode 21, this flowing via the resistor 25. However, in this case, the leakage current $I_L$ cannot reach the OP-AMP 22 owing to the DC blocking capacitor 23 which allows the varying current signal $I_S$ to pass but blocks the steady-state DC component $I_L$.

Circuit-wise, the arrangement shown in Fig. 2 works well. However, it is not applicable to a multi-pixel sensor of the kind used in γ-cameras where the pixels and the OP-AMPs are physically separated as discrete components, thus belying any possibility to connect the feedback resistor directly to the diode instead of across the OP-AMP. It will be borne in mind that the OP-AMP and associated circuitry are provided within the ASIC and disconnection of the feedback resistor is impossible Moreover, even assuming that the ASIC were redesigned so as to support the circuit topology shown in Fig. 2, this would then require that, in respect of each pixel, an external resistor be connected to the ASIC. The small physical dimensions of the PCB on which the ASIC is mounted in combination with the crowded circuitry and wiring associated therewith all militate against such possibility.

## SUMMARY OF THE INVENTION

It is therefore an object of the invention to provide an input circuit in a charge detector for reading an array of pixels in a 2-dimensional image sensor so as to allow accurate determination of the integrated charge signal, whilst blocking the reverse leakage current.

According to the invention, there is provided an input circuit for a charge detector, the input circuit comprising:

an amplifier having an input terminal and an output terminal,
a sensor element coupled to the input terminal for feeding a data signal thereto upon detection of a high energy particle and passing a leakage current in an absence of a high energy particle,
a controlled current source coupled to the sensor element for feeding a major component of the leakage current therethrough, and
a feedback resistor coupled across the input terminal and the output terminal of the amplifier for feeding a residual component of the leakage current to the sensor element;
the controlled current source being responsive to a change in voltage across the feedback resistor for regulating the major component of the leakage current so as to maintain the residual component thereof substantially constant.

## BRIEF DESCRIPTION OF THE DRAWINGS

In order to understand the invention and see how the same may be carried out in practice, a preferred embodiment will now be described, by way of non-limiting example only, with reference to the accompanying drawings, in which:

Fig. 1 is a circuit diagram showing part of a prior art reading circuit for reading a sensor pixel;
Fig. 2 is a circuit diagram showing part of an improved prior art reading circuit for reading a sensor pixel;

Fig. 3 is a circuit diagram showing schematically a detail of a reading circuit having a variable current source for feeding reverse leakage current to a diode in a pixel array;

Figs. 4 and 5 are circuit diagrams showing practical embodiments of the reading circuit shown in Fig. 3 employing a self-regulating current source;

Figs. 6a and 6b are a schematic diagram showing a system including a reading circuit for reading a sensor according to the invention;

Fig. 7 shows pictorially a multi-layer sensor according to the invention comprising a stacked array of image sensors; and

Fig. 8 shows graphically the effect of time walk in an integrated charge signal;

Figs. 9a and 9b show graphically a solution according to the invention to the problem associated with time walk of an integrated charge signal;

Fig. 10 is a schematic diagram showing a detail of the reading circuit according to the invention; and

Figs. 11a to 11f show graphically various waveforms associated with the reading circuit all drawn to a common time base.

## DETAILED DESCRIPTION OF PREFERRED EMBODIMENTS

Fig. 3 is a circuit diagram showing schematically a detail of an input circuit 30 for a charge detector reading charge produced when a high energy particle such as a $\gamma$-ray strikes a pixel constituted by a reverse biased diode 31. A variable current source 32 is coupled to a cathode of the diode 31 for feeding reverse leakage current thereto. An OP-AMP 33 having a feedback resistor 34 and capacitor 35 operates as a charge integrator that outputs an electric current proportional to the charge produced by the $\gamma$-ray striking the diode 31. The OP-AMP 33 functions as a charge-sensitive amplifier and, typically, the feedback resistor 34 has a value in excess of 100 M$\Omega$ in order to achieve low noise. The reverse leakage current of the diode 31 is shown as $I_L$, whilst the current produced when a $\gamma$-ray strikes the diode 31 is shown as $I_S$. Under steady-state conditions, when no $\gamma$-ray is absorbed, only the small leakage current $I_L$ flows through the diode 31. None of this current must flow through the feedback resistor 34 in order to avoid the voltage thus developed across the feedback resistor 34 saturating the OP-AMP 33.

Having described the circuit topology, the principle of the invention will now be explained. The voltage across the feedback resistor 34 is monitored using a voltmeter 35 and the current source 32 is regulated until the voltage shown on the voltmeter 35 is zero. When this happens, all of the leakage current is provided by the current source 32 and none flows through the feedback resistor 34.

In practice, it is rarely feasible to employ a current source, which requires manual adjustment and space considerations usually militate against the connection of a voltmeter across the feedback resistor 34. As noted above, when the circuit detail 30 is part of a reading circuit for reading charge produced by a pixel sensor having a large number of addressable pixels, it is normal to mount the reading circuit on an ASIC. Each of the pixels is then hard-wired to an appropriate solder pad on the ASIC leaving no room for the connection of the voltmeter 35 to the ASIC even if the terminals of the feedback resistor 34 were accessible, which is usually not the case.

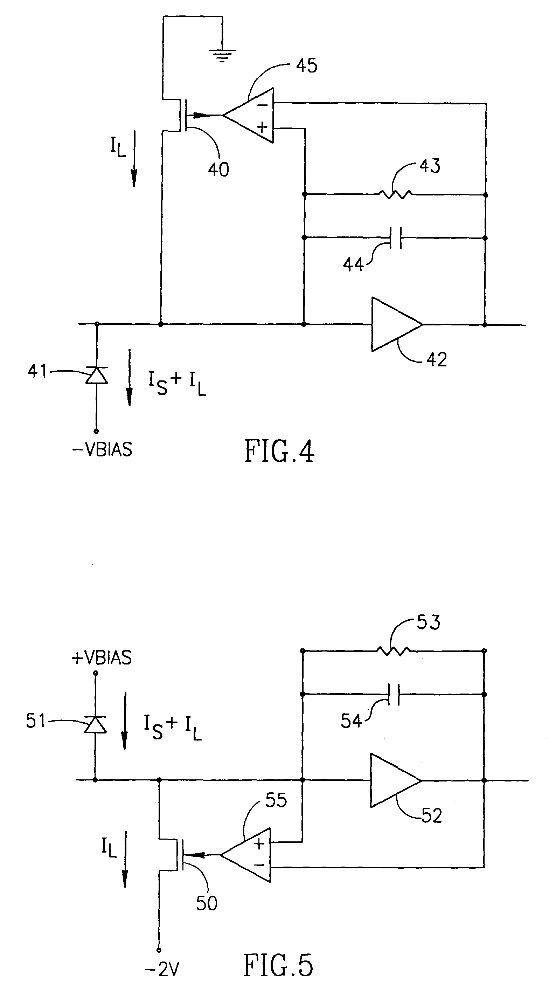

Fig. 4 shows a practical implementation of the circuit described above with reference to Fig. 3 wherein the current source is self-regulating, thus avoiding the need to monitor externally the voltage across the feedback resistor. A p-type MOSFET 40 (constituting an active element) is coupled to the cathode of a diode 41 for feeding reverse leakage current thereto. An OP-AMP 42 having a feedback resistor 43 and capacitor 44 operates as a charge integrator that outputs an electric current proportional to the charge produced by a $\gamma$-ray striking the diode 41. The voltage across the feedback resistor 43 is fed to an OP-AMP 45 such that the low voltage point is fed to the non-inverting input thereof and the high voltage point is fed to the inverting input thereof An output of the OP-AMP 45 acts as a control voltage fed to a gate terminal 46 of the MOSFET 40 (and constituting a control terminal thereof). The reverse leakage current of the diode 41 is shown as $I_L$, whilst the current produced when a $\gamma$-ray strikes the diode 41 is shown as $I_S$.

The circuit operates as follows. Any increase in the voltage across the feedback resistor 43 is fed to the inverting input of the OP-AMP 45 whose output consequently falls. The MOSFET 40 behaves as a linear resistor whose resistance is proportional to the control voltage fed to the gate terminal thereof Thus, as the gate voltage supplied by the OP-AMP 45 falls, so too does the resistance of the MOSFET 40 which, as a result, feeds more current therethrough. The current fed by the MOSFET 40 constitutes a major component of the leakage current $I_L$, a residual component being supplied via the feedback resistor 45. Consequently, if the major component of the leakage current $I_L$ supplied by the MOSFET 40 increases, the residual component supplied by the feedback resistor 45 decreases, thereby decreasing the voltage across the feedback resistor. The opposite occurs when the voltage across the feedback resistor 45 falls. In either case, the MOSFET 40 acts as a self-regulating current source tending to restore the voltage across the feedback resistor to its equilibrium value.

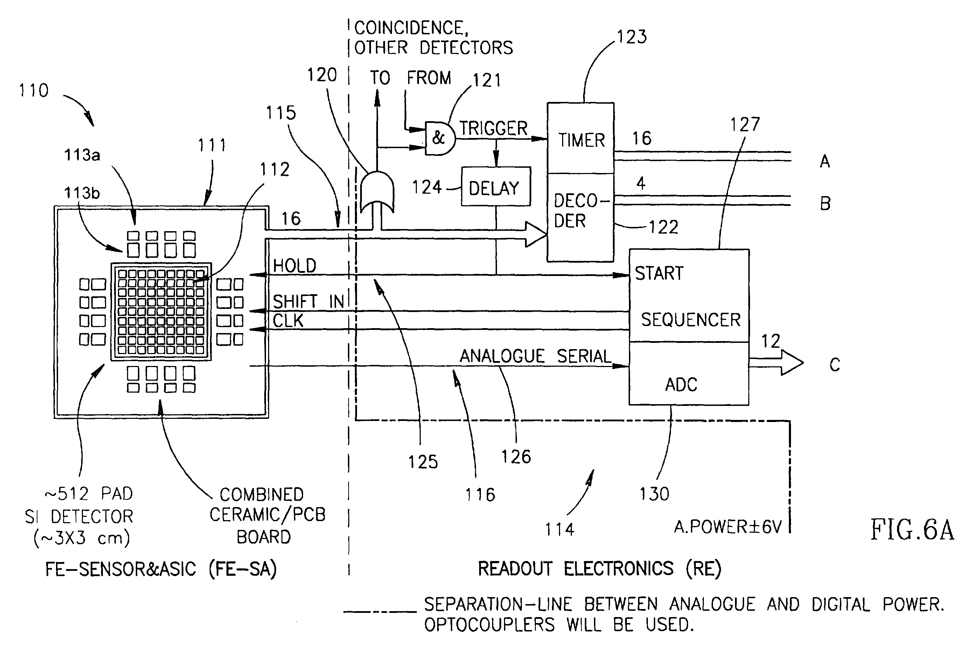

Fig. 5 shows an alternative embodiment of the circuit described above with reference to Fig. 4 wherein an n-type MOSFET 50 (constituting an active element) is coupled to the anode of a diode 51 for feeding reverse leakage current thereto. An OP-AMP 52 having a feedback resistor 53 and capacitor 54 operates as a charge integrator that outputs an electric current proportional to the charge produced by a γ-ray striking the diode 51. The voltage across the feedback resistor 53 is fed to an OP-AMP 55 such that the high voltage point is fed to the non-inverting input thereof and the low voltage point is fed to the inverting input thereof An output of the OP-AMP 55 acts as a control voltage fed to a gate terminal 56 of the MOSFET 50 (and constituting a control terminal thereof).

Operation of the circuit is as follows. Any increase in the voltage across the feedback resistor 53 is fed to the inverting input of the OP-AMP 55 whose output consequently falls. As the gate voltage supplied by the OP-AMP 55 falls, so too does the resistance of the MOSFET 50, which consequently sinks more current therethrough. The current passed by the MOSFET 50 constitutes a major component of the leakage current $I_L$, a residual component being supplied via the feedback resistor 53. Consequently, if the major component of the leakage current $I_L$ passed by the MOSFET 50 increases, the residual component supplied by the feedback resistor 53 decreases, thereby decreasing the voltage across the feedback resistor. The opposite occurs when the voltage across the feedback resistor 53 falls. In either case, the MOSFET 50 acts as a self-regulating current source tending to restore the voltage across the feedback resistor to its equilibrium value.

In both the circuits shown in Figs. 4 and 5, an equilibrium is established wherein the voltage across the feedback resistor stabilizes to the offset of the charge-sensitive amplifier constituted by the OP-AMPs 42 and 52, respectively, this being negligible.

When such an arrangement is used in a charge-sensitive amplifier forming part of a high energy particle detector, it is important that the current $I_S$ produced when a γ-ray strikes a sensor pixel (constituted by the diode 41 or 51) does not participate in the stabilizing loop. Such participation, if not prevented, would tend to reduce the signal current fed to the amplifier OP-AMP, thereby giving a false detector signal. In a Compton camera used for medical tomography, the signal magnitude serves as an indication as to whether the signal derives from Compton scattering by a tumor, and is therefore genuine, or derives from secondary scattering, and must therefore be ignored. Therefore, any reduction in the detector signal must be avoided. This can be achieved by making the time constant of the charge-sensitive amplifier OP-AMP much greater than that of the charge integrator constituted by the capacitor and feedback resistor. By such means, the stabilization loop is transient and has no long-term effect on a genuine sensor signal produced when a γ-ray strikes a pixel.

Having described in some detail the circuit according to the invention, there will now be described a system for reading a data signal emitted by an active pixel in a sensor module. It is to be noted that such a system is described in our co-pending EP 893,705, whose contents are nevertheless presented here substantially in full.

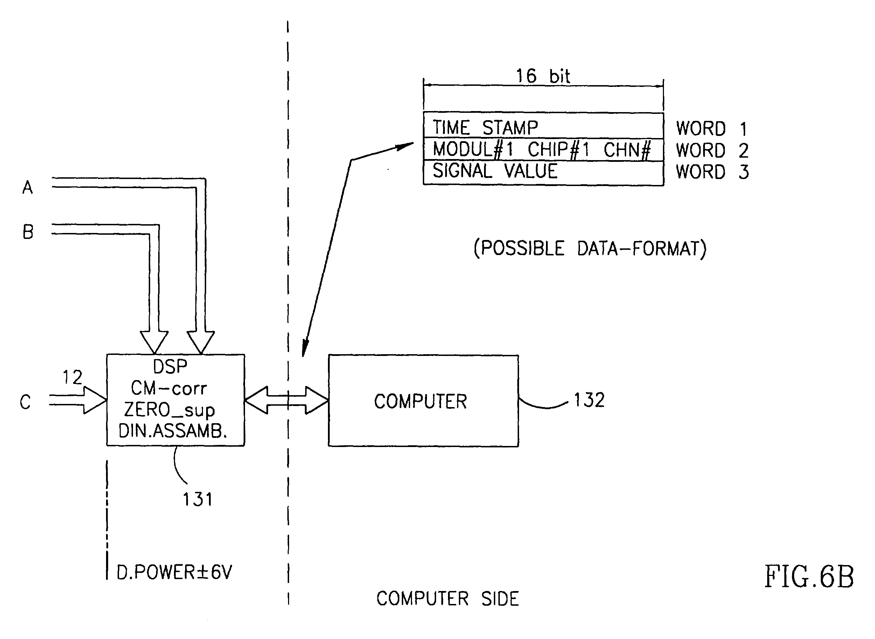

Figs. 6a and 6b are a schematic diagram showing a system depicted generally as 110 comprising a sensor module 111 having an array of 512 pixels 112 constituted by silicon diodes which are responsive to an incident γ-ray for producing a charge signal. By way of example, the sensor module 111 may be part of a Compton camera for use in tomographic imaging of a patient's body. Such a Compton camera is provided with two separate detectors: one of which is a multilayer sensor whose multiple layers serve to increase the Compton effect and each of which is provided with its own independent readout circuit for enabling the data signal to be read out. The second detector, which is not itself a feature of the invention, may be a similar pixel array or any other suitable sensor for absorbing the γ-ray which emerges from the first detector. As a result, the γ-ray gives up its residual energy in the second detector thereby allowing the angle of the γ-ray to be calculated in known manner.

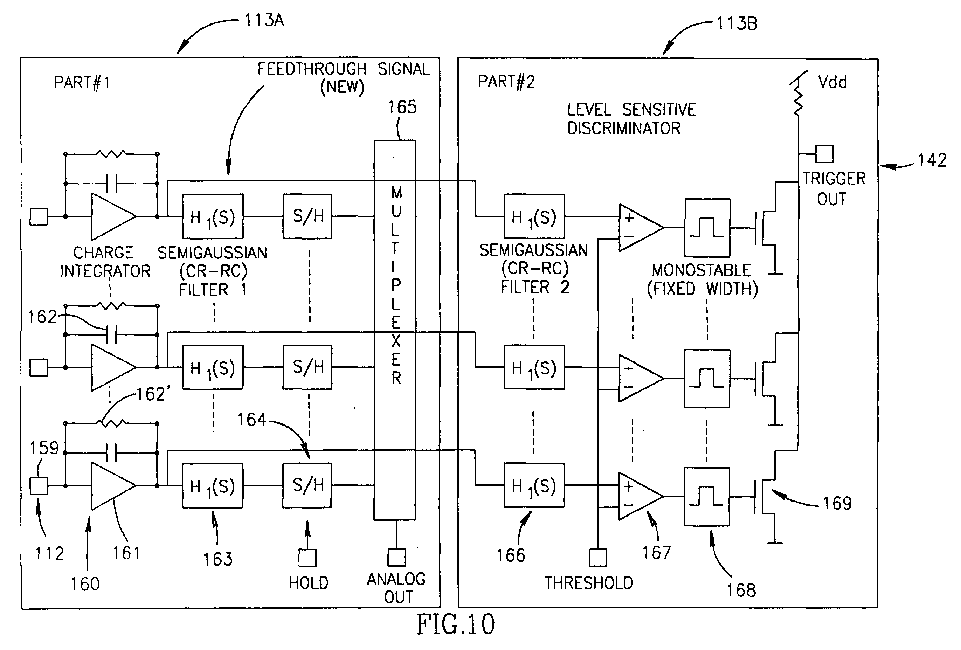

The present invention is thus applicable primarily to the first detector in which the pixel arrays 112 are arranged into 16 groups of pixels each having 32 pixels. The sensor module 111 includes on-chip discrimination circuitry in respect of each of the 16 groups of pixels in the pixel array 112, in the form of a pair of application specific integrated circuits (ASICs) 113a and 113b which may, if desired, be combined in a single ASIC. Details of the ASICs 113a and 113b are given below with reference to Fig. 10 of the drawings. Respective output channels of the discrimination circuitry are fed to a readout circuit 114 for sequentially selecting a different group of pixels and coupling the pixels in the selected group to respective first and second data buses 115 and 116. Specifically, the pixels in each group are fed to a multi-input discriminator so as to derive a composite signal which is fed to a corresponding data line in the first data bus 115. Thus, the composite signal level is derived from all of the pixels in the respective group and is HIGH if any of the pixels in the group is "active" and is otherwise LOW. Consequently, only one data line will be HIGH indicating which of the 16 groups of pixels is "active" whilst the other 15 data lines corresponding to the remaining 15 groups containing, in total, some 480 pixels, are LOW, showing that none of the 480 pixels is "active". Thus, by grouping the 512 pixels as described into 16 groups and discriminating between the one active group and the remaining 15 inactive groups, the location of the one "active" pixel is very significantly narrowed down; although of course, at this stage, it is not yet known which of the 32 pixels in this group is the "active" pixel.

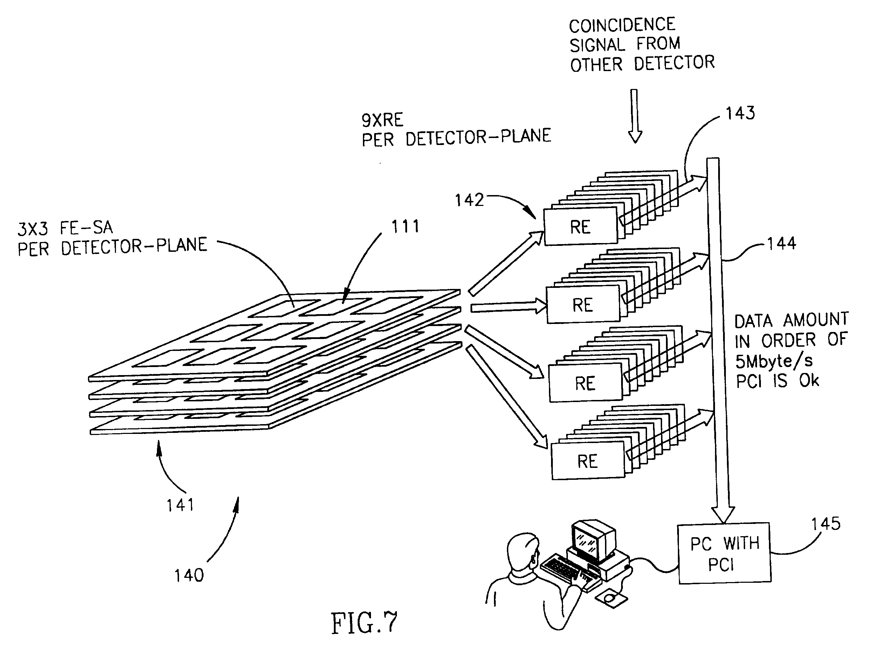

All 16 data lines in the first data bus 115 are connected to respective inputs of a 16 input OR-gate 120 (constituting a first logic circuit) whose output is consequently HIGH (constituting a first logic level) if any one or more of the 16 data lines is HIGH indicating that the corresponding group is "active". If none of the 512 pixels in the sensor module 111 is "active", then the output of the OR-gate 120 is LOW (constituting a second logic level). As will be explained below, with particular reference to Fig. 7 of the drawings, several sensor modules may be assembled so as to form a multi-layer image sensor each having a plurality of sensor modules. Each sensor module has an associated OR-gate 120 and the output of the OR-gate in each module is fed to one input of a 2-input AND-gate 121 (constituting a second logic circuit) to whose second input is fed an output from a second detector (not shown). Consequently, the output of the AND-gate 121 in each sensor module is HIGH only if the outputs of at least one of the OR-gates 120 in the respective sensor module is HIGH, and at the same time the output of the second detector is HIGH. The AND-gate 121 thus allows time coincidence of charge emissions emanating from both the first and second detectors to be established in real time. A γ-ray may strike the image sensor obliquely and if it is partially absorbed in one layer then its angle will change thus permitting its subsequent detection.

A decoding circuit 122 is coupled to the first data bus 115 and is responsive to the composite signal on each of the data lines thereof for determining which of the data line is HIGH thereby establishing an identity of the active group. A a timing circuit 123 is coupled to the output of the OR-gate 120 via the AND-gate 121 and is responsive to the output of the OR-gate 120 being HIGH (i.e. the first logic level) for generating a time stamp corresponding to a time of creation of the first logic level which is substantially coincident with the pixel response. A delay gate 124 (constituting a delay circuit) coupled to the timing circuit 123 is responsive to the output of the OR-gate 120 being HIGH for generating a time delay $t_D$ which is fed via a delay line 125 to a latch in a sample and hold circuit (shown as 164 in Fig. 10) within the ASIC 113 so that the data signal generated by the "active" pixel may be sampled at a time delay $tp = \Delta t + t_D$ after its generation, $\Delta t$ being the time difference between the actual charge emission and its discrimination.

The second data bus 116 is constituted by an analog data line 126 which is coupled via a sequencer 127 (constituting a selection circuit) to each of the pixels in a selected one of the groups for receiving thereon respective signal levels of each of the pixels in the selected group. The sequencer 127 is responsive to a start signal which is fed to a start input thereof via the delay line 125 for cycling through the pixel addresses in the active group so as to output serially on the analog data line 126 an analog signal corresponding to the signal level of each pixel in turn in the active group. The analog data line 126 is coupled to an analog-to-digital converter (ADC) 130, the output of which is a digital signal representative of the signal level of the corresponding pixel in the active group.

The digital signal output by the ADC 130 is fed to a digital signal processor (DSP) 131 (constituting a discriminating circuit) which is programmed to compare the signal level of each pixel in the selected group with a discriminating threshold so as to identify the active pixel as that pixel whose signal level exceeds the discriminating threshold.

The DSP 131 also functions as a common mode noise level determination circuit for determining an average common mode noise level associated with the 131 pixels in the selected group whose signal levels are not commensurate with an "active" pixel. The common mode noise levels of the 131 inactive pixels is averaged and then subtracted from the signal level of the "active" pixel so as to correct for common mode noise. The DSP 131 produces a digital data stream containing data representative of the module number, the active group identity, the active pixel identity, the time stamp of the active pixel and the common mode noise-corrected signal level thereof. The resulting digital data stream is then transmitted to a computer 132 where it is processed as required: this not being a feature of the present invention. The module number is a pre-programmed code, which is down-loaded into the corresponding sensor module 111 and which thus identifies from which sensor module a data signal was emitted. The time stamp specifies the time based on a common real time clock (not shown) at which a charge emission occurred by the identified pixel. These data are relevant when coincident data from the first detector is combined with the corresponding data from the second detector so as to calculate the location of the incident γ-ray and its angle of incidence. It should, however, be noted that the time stamps are not used to establish time coincidence of a charge emission from the first and second detectors: this being established in real time using logic gates as explained above with reference to Figs. 6a and 6b of the drawings.

Separate power supplies (not shown) are provided for the analog and digital sections of the reading circuit 114, so that the analog and digital power is distinct as shown by the chain-dotted line. In order to maintain the desired differentiation between analog and digital components whilst nevertheless allowing for unimpeded data transfer between the two, optocouplers are employed.

Fig. 7 shows pictorially a multi-layer sensor 140 being part of a first detector for a Compton camera and having five parallel identical sensor planes each designated 141 and comprising an array of nine sensor modules 111 as described above with reference to Fig. 6a of the drawings. Each of the sensor modules 111 in each sensor plane 141 is coupled to a respective reading circuit 142, so that nine reading circuits are required for each sensor plane. Respective outputs 143 of each of the reading circuits 142 are coupled via a data bus 144 to a computer 145. A γ-ray impinging on the sensor 140 has sufficient energy to penetrate through all the layers 141 thereof, but produces a charge data signal only if it is partially absorbed by a pixel in at least one sensor plane. As noted above, the provision of multiple layers increases the probability that a Compton effect will occur in at least one pixel of the sensor. It should be noted that the same objective can also be realized by increasing the surface area of each sensor plane.

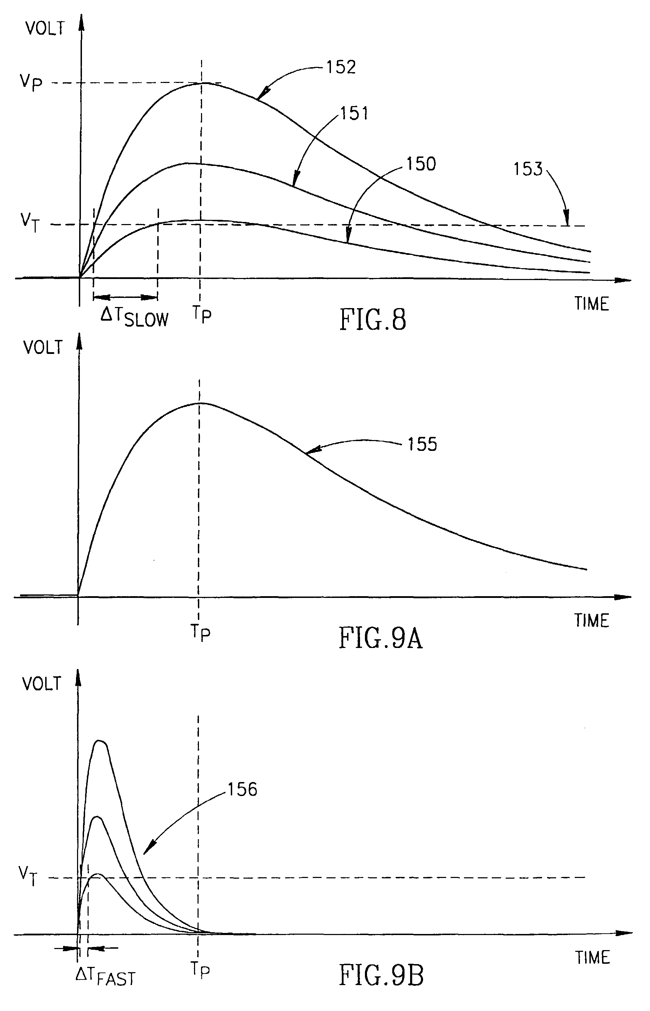

In order that the charge signal emitted by an "active" pixel can be read by the reading circuit 142, the charge signal, after pre-amplification, must first be shaped whereupon its peak magnitude may be sampled and measured. Fig. 8 shows graphically three curves 150, 151 and 152 representing respective charge signals emanating at the same time $t_0$ and each having a different peak value $V_P$.

Referring back to the description of the reading circuit with reference to Fig. 6a of the drawings, it will be recalled that a time delay $t_D$ is fed via a delay line 125 to a latch in a sample and hold circuit (shown as 164 in Fig. 10) within the ASIC 113a so that the data signal generated by the "active" pixel may be sampled at a time delay $t_P$ after its generation. The time delay $t_D$ may be predetermined based on the value of $\Delta t$ and the peak tine $t_P$ which is known from the RC time-constant of the shaper, so that if the start of the signal at time $t_0$ is known, then the curve may be sampled exactly at the peak time $t_P$ so as to obtain the peak value $V_P$. In fact, this is not feasible because the time $t_0$ of the charge signal emanating from the "active" pixel can never be determined precisely since it is first necessary to discriminate between actual pixel data resulting from an incident γ-ray and the signal baseline level. Such discrimination is performed by comparing the signal with a predetermined threshold 153 using a conventional comparator. The time taken for each of the signals to pass the threshold 153 depends on the peak value $V_P$ of the signal and thus varies from one signal to another. This effect is known as "time walk" and must be compensated for in order to sample each of the three signals at the correct time so as to obtain the respective peak value. Without such compensation, there is no constant delay between the time at which each curve passes through the threshold and the time at which the curve reaches its peak value.

Figs. 9a and 9b show graphically a solution to the problem of time walk by means of which the desired compensation can be effected. Thus, Fig. 9a shows a typical integrated charge curve 155 having a known peak time $t_P$. As explained above, this in itself is not sufficient to measure accurately the peak value $V_P$ because it is first necessary to determine a reliable time origin $t_0$ using a threshold discriminator as explained above.

In order to achieve this objective, the invention provides a second shaper having a very much faster time constant so as to produce a sharp curve 156 (shown in Fig. 9b) which crosses the threshold after a time $\Delta t$ very much less than the peak time $t_P$ of the slow shaper. Having thus determined from the curve 156 that the signal corresponds to pixel data and not the signal baseline level, the first curve 155 may be sampled after a time delay $t_D$ equal to $t_P - \Delta t$. It is, of course, true that $\Delta t$ is not known precisely because the fast rise time curve 156 is also subject to time walk and therefore $\Delta t$ depends on the peak value thereof However, since the value of $\Delta t$ is very small compared to the value of $t_P$, any error in $\Delta t$ has negligible effect on the delay $t_P - \Delta t$ after which the first curve 155 is sampled in order to read the value of $t_P$.

Fig. 10 shows a detail of the reading circuit 142 illustrating the application of duplicated shapers having different time constants in order to compensate for time walk. To the extent that the reading circuit 142 contains components that are shown in other figures also, identical reference numerals will be employed. Thus, each pixel 112 in a selected group is fed via a solder pad 159 to an integrator 160 formed by a preamplifier 161 having a feedback capacitor 162 and resistor 162'. The integrated output of the preamplifier 161 is filtered by a first CR-RC shaper 163 (constituting a slow shaper) and then passed to a sample and hold unit 164. The analog output of the sample and hold unit 164 is multiplexed by a multiplexer 165 so that the signal corresponding to each of the 132 pixels in each group can be sampled and processed.

It should be noted that in Fig. 10, the pixel 112 is referenced in the first ASIC 113a for the sake of clarity only. In practice, the pixel 112 is contained within the sensor module 111 which is a physically distinct unit from the ASIC 113a and each of whose pixels 112 is hard-wired to the respective solder pad 159 within the ASIC 113a. The input circuit shown in either Fig. 4 or 5 is likewise connected to the same solder pad 159 and ensures that the current flowing through the feedback resistor 162' is maintained at its equilibrium value equal to the offset of the preamplifier 161.

The output of the preamplifier 161 is also fed to a second CR-RC shaper 166 (constituting a fast shaper) having an integration time (i.e. peak time) which is in the order of ten times shorter than that of the first shaper 163. The output of the second shaper 166 is fed to a level discriminator 167 whose threshold is of sufficient magnitude to discriminate between a genuine signal and the signal baseline level. The output of the level discriminator 167 is fed to a monostable 168 whose output is coupled to the gate of a MOSFET 169. The monostable 168 is thus responsive to an "active" pixel within the respective group for producing a short trigger pulse for switching on the MOSFET 169. The MOSFETs 169 of each group are connected in wired OR configuration so that if any of the pixels in the selected group is "active" the combined output of the MOSFETs 169 will be HIGH.

Thus, the second shaper 166 permits very fast discrimination in respect of an "active" pixel whereafter the slow integrated signal generated by the first shaper 163 may be accurately sampled after a constant delay time $t_D$ in order to establish its peak value $V_P$.

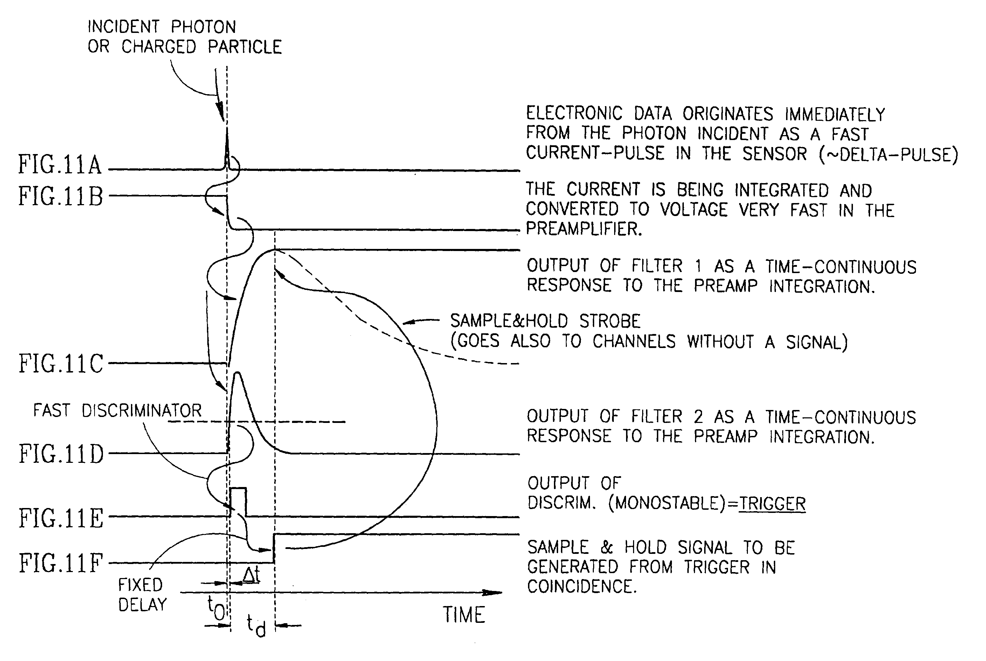

Figs. 11a to 11f summarize the various signal levels associated with an "active" pixel all drawn according to a common time base. Thus, Fig. 11a shows the actual charge signal emitted by a pixel consequent to being struck by a γ-ray. As explained above, this signal is a sharp current pulse starting at time $t_0$, almost instantaneously rising to a peak value and then trailing off to zero.

Fig. 11b represents the corresponding waveform after pre-amplification. As noted above, the preamplifier integrates the charge data signal so as to produce an analog voltage signal having a sharp change in level upon emission of the data signal. The sharp change in level defines the start time $t_0$ of the data signal.

Figs. 11c and 11d show respectively the slow and fast shaped data signals. In Fig. 11c, the shaped signal rises to a peak value $V_P$ at a time $t_P$ after the start time $t_0$ and then trails off to zero as shown by the dotted line. The waveform must be sampled and held at the time $t_P$ in order to capture the peak value $V_P$. It is clearly shown in Fig. 11d that the fast shaped signal rises through the threshold alter a time interval $\Delta t$ following the start time $t_0$.

Fig. 11e shows the output of the monostable 168 (shown in Fig. 10) which is a sharp square wave pulse generated at time $t_0 + \Delta t$ and which is fed via the MOSFET 169 to the delay circuit 124 (shown in Fig. 6a) so as to trigger the delay circuit 124 whereby after a further delay time $t_D$ equal to $t_P - \Delta t$ the slow integrated signal shown in Fig. 11c is sampled at its peak value $V_P$.

It will be appreciated that whilst the use of parallel discrimination using slow and fast shapers has particular benefit to the sensor according to the invention, the principle of parallel discrimination may find more general application. More particularly, it is to be noted that, where high speed is not essential, such discrimination may advantageously be employed with known image sensors all of whose pixels are read out, so as to allow the pixel data to be read with greater accuracy. Likewise, it will be apparent that other modifications may be effected to the particular embodiments as described without departing from the scope of the invention, which is defined by the claims.

It will be appreciated that modifications may be effected to the particular embodiments as described without departing from the scope of the invention. Thus, for example, whilst the invention has been described with particular regard to the detection of γ-ray emissions, it is to be understood that the same principles are equally well applicable for the detection of other high energy particles. As will further be appreciated, such high energy particles may be photons or charged particles.

It will also be understood that whilst the preferred embodiment relates specifically to the use of a charge-sensitive amplifier, the invention is also applicable to the use of current amplifiers even though they are inherently more noisy.

Likewise, although the use of the multi-pixel sensors within a Compton camera has been described, it is to understood that the same principles are equally well suited for use with a hybrid photon detector and for readout of photomultiplier tubes.

It should also be pointed out that when the sensor modules are based on silicon, each pixel is effectively a diode. However, other semiconductor sensors may also be employed in which case the pixels are high resistive elements.

**Claims**

1. An input circuit (30) for a charge detector having a sensor element (31, 41, 51), the input circuit comprising:

> an amplifier (33, 42, 52) having an input terminal and an output terminal,
> the sensor element (31, 41, 51) being coupled to the input terminal for feeding a data signal thereto upon detection of a high energy particle and passing a leakage current in an absence of a high energy particle,
> a controlled current source (32, 40, 50) coupled to the sensor element for feeding a major component of the leakage current therethrough, and
> a feedback resistor (34, 44, 54) coupled across the input terminal and the output terminal of the amplifier for feeding a residual component of the leakage current to the sensor element;
> the controlled current source being responsive to a change in voltage across the feedback resistor for regulating the major component of the leakage current so as to maintain the residual component thereof substantially constant.

2. The input circuit according to Claim 1, wherein:

> the controlled current source includes a supply voltage ($-V_{BIAS}$, $+V_{BIAS}$) fed through an active element (40, 50) having a control terminal for applying thereto a control voltage and having a resistance which is dependent on a magnitude of the control voltage, and
> the control voltage is a function of a voltage across the feedback resistor.

3. The input circuit according to Claim 2, wherein:

> the active element (40, 50) is a MOSFET and the control terminal is a gate terminal thereof, which is responsively coupled to the feedback resistor;
> whereby a change in voltage across the feedback resistor induces a change of like polarity in the control voltage fed to the gate terminal and therefore induces a change of like polarity in the major component of the leakage current conducted by the MOSFET, thereby inducing a change of opposite polarity in the residual current fed by the feedback resistor and tending to maintain the voltage across the feedback resistor at a stable level.

4. The input circuit according to Claim 3, wherein an increase in the voltage across the feedback resistor is fed to an inverting input of an OP-AMP having an output connected to the gate terminal of the MOSFET.

5. The input circuit according to Claim 4, wherein:

the MOSFET is a p-type device (40), and a cathode of the sensor element (41) is coupled to the input terminal of the amplifier (42).

6. The input circuit according to Claim 4, wherein:

the MOSFET is an n-type device (50), and an anode of the sensor element (51) is coupled to the input terminal of the amplifier (52).

7. The input circuit according to any one of Claims 1 to 6, wherein the amplifier is a current-sensitive device.

8. The input circuit according to any one of Claims 1 to 6, wherein:

the amplifier (33, 42, 52) is a charge-sensitive device, and a capacitor (35, 44, 54) is connected between the input terminal and the output terminal of the amplifier for integrating a charge signal emitted by the sensor element.

9. The input circuit according to Claim 8, wherein the amplifier has a time constant which is much larger than that of the capacitor and feedback resistor in combination, in order that substantially none of the leakage current be provided by said data signal.

10. The input circuit according to any one of the preceding claims, wherein the amplifier and feedback resistor are contained within a circuit (113a, 113b) which is physically discrete from the sensor element (112).

11. A sensor module (112) having a plurality of sensor elements each being coupled to an input circuit according to any one of the preceding claims.

12. A system (110) for reading a data signal emitted by an active pixel in the sensor module (111) according to Claim 11, wherein the sensor module has a plurality of addressable pixels arranged into at least two groups, the system comprising:

an identifying circuit (113a, 113b) commonly coupled to each of said groups of pixels and responsive to said data signal for identifying an active group containing the active pixel without identifying the active pixel itself, and a reading circuit (114) responsively coupled to the identifying circuit for reading a magnitude of the data signal in respect of each pixel in the active group, so as to identify the active pixel.

13. The system according to Claim 12, wherein the reading circuit (114) comprises:

a discrimination circuit (131) for comparing a magnitude of each data signal with a discriminating threshold so as to identify an active pixel as that pixel whose signal magnitude exceeds said discriminating threshold.

14. The system according to Claim 12, wherein the discrimination circuit (131) further includes:

a common mode noise level determination circuit for determining an average common mode noise level associated with said remaining pixels, and a common mode noise correction circuit coupled to the common mode noise level determination circuit for subtracting said average common mode noise level from the signal level of the active pixel.

15. The system according to any one of Claims 12 to 14, wherein said sensor module (111) is accommodated within a layer of a multi-layer sensor (140).

16. The system according to any one of Claims 12 to 15, wherein the or each sensor module (111) is a component in a first detector in which an incident high energy particle is partially absorbed and emerges therefrom with reduced energy, and there is further provided a second detector for totally absorbing the incident high energy particle emerging from the first detector.

17. The system according to Claim 16, further including:

a timing circuit (123) coupled to both the first and second detectors for associating respective time stamps according to a common time base with the "active" pixel in the first detector and with a known location in the second detector at which the high energy particle is absorbed, and

a computer (132) coupled to the first and second detectors and being responsive to said time stamps of a data signal emanating from both the first and second detectors substantially simultaneously for computing a location of the "active" pixel and a direction of said high energy particle.

18. The system according to Claim 13, wherein the reading circuit (114) includes:

an initiation circuit (166) responsive to said electrical signal for producing an initiation signal at said start time $t_0$, and

a level determination circuit (163, 164, 165) responsively coupled to the initiation circuit for measuring the magnitude of the data signal at a predetermined time interval $\Delta t$ after said initiation signal so as to discriminate between a genuine signal and signal baseline level.

19. The system according to Claim 18, wherein:

the electrical signal is emitted as a sharply rising current pulse, and

the initiation circuit comprises a preamplifier (161) including an integration circuit (160) for integrating the current pulse so as to produce an analog voltage step having a sharp change in level upon emission of the electrical signal.

20. The system according to Claim 18 or 19, wherein the data signal is derived from an emission of electric charge and the reading circuit (142) further includes at least one shaper (163) in respect of each pixel in the active group for shaping the charge in order to generate a proportional voltage signal.

21. The system according to Claim 20, wherein each pixel is a semi-conductor diode for emitting charge when struck by high energy radiation.

22. The system according to Claim 20, wherein each pixel is a high resistive element.

23. The system according to any one of Claims 20 to 22, wherein the reading circuit (142) includes in respect of each pixel in the active group:

a fast shaper (166) having a fast time constant and being responsive to said initiation signal for shaping the charge so as to generate a fast response curve which quickly rises above a predetermined threshold,

a slow shaper (163) having a slow time constant and being responsive to said initiation signal for shaping the charge so as to generate a slow response curve having a high signal to noise ratio,

a delay circuit (124) coupled to the fast shaper for determining a time delay $\Delta t$ for the fast response curve to exceed said predetermined threshold, and

a sampling circuit (164) coupled to the delay circuit and to the slow shaper for sampling the slow response curve at a further time interval $t_p - \Delta t$ where $t_P$ is the time at which the slow response curve reaches its peak value so as to sample the slow response curve substantially at its peak value.

24. The system according to Claim 23, wherein the fast and slow shapers are provided in a single integrated circuit.

25. The system according to Claim 23, wherein the fast and slow shapers are provided in separate interconnected integrated circuits (113a, 113b).

26. The system according to Claim 24 or 25, including:

a first data bus (115) coupled to each group of pixels in said sensor module for feeding along parallel data lines within said first data bus a composite signal level derived from all of the pixels in the respective group,

a decoding circuit (122) coupled to the first data bus and responsive to said composite signal for determining an identity of the active group,

a first logic circuit (120) coupled to the first data bus for producing a first logic level if one of the signal levels in said first data bus is commensurate with an "active" pixel and for producing a second logic level otherwise,

a timing circuit (123) coupled to the first logic means and responsive to the first logic level for generating a time stamp corresponding to a time of creation of said first logic level,

a delay circuit (124) coupled to the timing circuit and responsive to the first logic level for generating a time delay equal to said time interval $t_P - \Delta t$,

a second data bus (116) coupled via a selection means (127) to each of the pixels in a selected one of said groups for receiving thereon respective signal levels of each of the pixels in the selected group,

a discriminating circuit (131) coupled to the second data bus for comparing the signal level of each pixel in the selected group with a discriminating threshold so as to identify the active pixel as that pixel whose signal level exceeds said discriminating threshold,

a common mode noise level determination circuit (131) coupled to the second data bus for determining an average common mode noise level associated with the pixels in the selected group whose signal levels are not commensurate with an "active" pixel, and

a processor (131) coupled to the timing circuit (123) and to the common mode noise level determination circuit (131) for determining a common mode noise-corrected signal level of the "active" pixel and for producing a digital data stream containing data representative of the active group identity, the active pixel identity, the time stamp and the common mode noise-corrected signal level.

27. The system according to Claim 26, wherein:

an analog to digital converter (130) is coupled to the second data bus for converting the signal levels of the pixels in the selected group to an equivalent digital signal, and

the processor is a digital signal processor (131).

28. The system according to Claim 23, wherein:

said sensor module (111) is accommodated within a first detector in which an incident high energy particle is partially absorbed and emerges therefrom with reduced energy, and there is further provided:

at least one second detector for totally absorbing the incident high energy particle emerging from the first detector,

a second logic circuit (121) coupled to an output of the respective first logic circuit (120) in each sensor module of the first detector and to an output of the at least one second detector for rejecting a signal in said first detector which has no counterpart in the at least one second detector;

thereby discriminating between a genuine signal which is detected by both detectors and random noise emitted randomly by said detectors.

29. The system according to any one of Claims 12 to 28, wherein the sensor module is part of a detector in a Compton camera.

30. The system according to any one of Claims 12 to 28, wherein the sensor module is part of a detector in a hybrid photon detector.

31. The system according to any one of Claims 12 to 28, wherein the sensor module is part of a photom-

ultiplier tube.

FIG.1

FIG.2

FIG.3

$I_L$

45

40

43

44

42

$I_S + I_L$

41

−VBIAS

FIG.4

+VBIAS

53

51

$I_S + I_L$

54

55

52

$I_L$

50

−2V

FIG.5

FIG.6A

110

111

112

113a
113b

~512 PAD
SI DETECTOR
(~3X3 cm)

COMBINED
CERAMIC/PCB
BOARD

FE-SENSOR&ASIC (FE-SA)

115

16

HOLD

SHIFT IN
CLK

COINCIDENCE,
OTHER DETECTORS

120    TO  FROM   121

&   TRIGGER

124   DELAY

125

116    126

114

TIMER   16

DECO-
DER

122

123

START

SEQUENCER

ANALOGUE SERIAL

ADC

130

A.POWER±6V

127

A

4

B

12

C

READOUT ELECTRONICS (RE)

SEPARATION-LINE BETWEEN ANALOGUE AND DIGITAL POWER.
OPTOCOUPLERS WILL BE USED.

EP 1 016 882 A2

16 bit

| TIME STAMP | WORD 1 |
| MODUL#1  CHIP#1  CHN# | WORD 2 |
| SIGNAL VALUE | WORD 3 |

(POSSIBLE DATA-FORMAT)

A

B

12

C

DSP
CM-corr
ZERO_sup
DIN.ASSAMB.

131

D.POWER±6V

COMPUTER

132

COMPUTER SIDE

FIG.6B

COINCIDENCE SIGNAL FROM OTHER DETECTOR

9XRE PER DETECTOR-PLANE

3X3 FE-SA PER DETECTOR-PLANE

143

144

DATA AMOUNT IN ORDER OF 5Mbyte/s PCI IS Ok

145

PC WITH PCI

142

RE

RE

RE

RE

111

141

140

FIG.7

FIG.8

FIG.9A

FIG.9B

FIG.10

EP 1 016 882 A2

INCIDENT PHOTON
OR CHARGED PARTICLE

FIG.11A

ELECTRONIC DATA ORIGINATES IMMEDIATELY
FROM THE PHOTON INCIDENT AS A FAST
CURRENT−PULSE IN THE SENSOR (~DELTA−PULSE)

FIG.11B

THE CURRENT IS BEING INTEGRATED AND
CONVERTED TO VOLTAGE VERY FAST IN THE
PREAMPLIFIER.

OUTPUT OF FILTER 1 AS A TIME−CONTINUOUS
RESPONSE TO THE PREAMP INTEGRATION.

SAMPLE&HOLD STROBE
(GOES ALSO TO CHANNELS WITHOUT A SIGNAL)

FIG.11C

FAST DISCRIMINATOR

OUTPUT OF FILTER 2 AS A TIME−CONTINUOUS
RESPONSE TO THE PREAMP INTEGRATION.

FIG.11D

OUTPUT OF
DISCRIM. (MONOSTABLE)=TRIGGER

FIG.11E

FIG.11F

SAMPLE & HOLD SIGNAL TO BE
GENERATED FROM TRIGGER IN
COINCIDENCE.

FIXED
DELAY

$\Delta t$

$t_0$

$t_d$

TIME

EP 1 016 882 A2